# EUROPÄISCHE PATENTANMELDUNG

(11) **EP 4 354 153 A1**
(43) Veröffentlichungstag der Anmeldung: **17.04.2024**
(21) Anmeldenummer: 23202523.9
(22) Anmeldetag: 09.10.2023
(51) Int. Cl.: G01R 1/067

(54) **HOCHFREQUENZ-PRÜFSTIFTVORRICHTUNG UND VERFAHREN**

(30) Priorität: 11.10.2022 DE 102022126295
(71) Anmelder: Ingun Prüfmittelbau GmbH, 78467 Konstanz (DE)
(72) Erfinder: Breul, Peter, 78467 Konstanz (DE); Schmid, Ralf, 78467 Konstanz (DE)
(74) Vertreter: Patent- und Rechtsanwälte Behrmann Wagner PartG mbB

(57) **Zusammenfassung**

Die Erfindung betrifft eine Hochfrequenz-Prüfstiftvorrichtung (10) und ein Verfahren zum lösbaren Kontaktieren eines Kontaktpartners, umfassend eine wenigstens abschnittsweise hülsenartig ausgebildete Gehäuseeinrichtung und eine abschnittsweise in der Gehäuseeinrichtung angeordnete Kontakteinrichtung (12), wobei die Prüfstiftvorrichtung zur Zusammenführung mit dem Kontaktpartner entlang einer Längserstreckungsrichtung der Prüfstiftvorrichtung ausgebildet ist, wobei die Kontakteinrichtung zumindest ein Prüfkontaktelement (28) aufweist, welches zum elektrischen Kontaktieren eines Kontaktelements des Kontaktpartners seitlich zu der Längserstreckungsrichtung ausgebildet ist, wobei die Kontakteinrichtung derart ausgebildet ist, dass mittels des Prüfkontaktelements ein in der Längserstreckungsrichtung betrachtet benachbart einem ersten Kontaktbereich des Kontaktelements angeordneter zweiter Kontaktbereich des Kontaktelements unter Übergreifen des ersten Kontaktbereichs in der Längserstreckungsrichtung seitlich zu der Längserstreckungsrichtung kontaktierbar ist.

## Beschreibung

Die vorliegende Erfindung betrifft eine Hochfrequenz-Prüfstiftvorrichtung und ein Verfahren zum lösbaren, seitlichen Kontaktieren eines Kontaktpartners im Hochfrequenzbereich.

Derartige Prüfstiftvorrichtungen sind aus dem Stand der Technik allgemein bekannt und werden in Prüffeldern oder anderen Prüfkontexten benutzt, um einen Kontaktpartner, beispielsweise eine einen geeigneten Buchsenabschnitt aufweisende Elektronikbaugruppe, auf Funktionsfähigkeit zu überprüfen. Hierbei wird die Prüfstiftvorrichtung als Stecker derart auf den zu prüfenden Kontaktpartner aufgesetzt, dass Prüfkontaktelemente einer Kontakteinrichtung der Prüfstiftvorrichtung Kontaktelemente des Kontaktpartners elektrisch kontaktieren. Anschließend werden über eine geeignete Kontaktierung Prüfsignale bzw. Hochfrequenzsignale auf den Kontaktpartner aufgebracht bzw. vom Kontaktpartner auf die Prüfstiftvorrichtung übertragen.

Je nach Ausbildung des Kontaktpartners bzw. Anordnung der Kontaktelemente an einem Gehäuse des Kontaktpartners erfolgt die Kontaktierung des Kontaktpartners bzw. der Kontaktelemente mittels der Prüfkontaktelemente stirnseitig oder seitlich.

Bei der Kontaktierung der Kontaktelemente mittels der Prüfkontaktelemente kommt es regelmäßig zu einem Zerkratzen der typischerweise veredelten bzw. vergoldeten Kontaktelemente, welches einerseits für Abnehmer von mittels einer Prüfstiftvorrichtung geprüften Kontaktpartnern zumindest bereichsweise unerwünscht ist und andererseits je nach Zerkratzungsgrad eine Qualität einer Kontaktierung der Kontaktpartner, wie Buchsen, mit bei deren bestimmungsgemäßer Verwendung mit diesen zusammenwirkenden Verbindungspartnern, wie Steckern, nachteilhaft vermindern kann. Gerade bei einer seitlichen Kontaktierung eines als eine Buchse ausgebildeten Kontaktpartners mittels einer Prüfstiftvorrichtung, bei dem die Kontaktelemente an einer Seitenwand eines Gehäuses des Kontaktpartners angeordnet sind, kommt es infolge eines Zusammenführens der Prüfstiftvorrichtung mit dem Kontaktpartner bzw. eines Einführens der Prüfstiftvorrichtung in die Buchse entlang einer Längserstreckungsrichtung der Prüfstiftvorrichtung längs eines Weges, um den die Prüfkontaktelemente die Kontaktelemente kontaktierend relativ zu den Kontaktelementen beim Zusammenführen bzw. Einführen bewegt werden, zu verstärkten Kratzspuren auf den seitlich angeordneten Kontaktelementen.

Der vorliegenden Erfindung liegt daher die Aufgabe zugrunde, eine Hochfrequenz-Prüfstiftvorrichtung und ein Verfahren zum lösbaren Kontaktieren eines Kontaktpartners vorzuschlagen, welche bzw. welches eine kratzarme Kontaktierung des Kontaktpartners ermöglicht.

Diese Aufgabe wird durch eine Hochfrequenz-Prüfstiftvorrichtung mit den Merkmalen des Anspruchs 1 und ein Verfahren mit den Merkmalen des Anspruchs 15 gelöst.

Die erfindungsgemäße Hochfrequenz-Prüfstiftvorrichtung zum lösbaren Kontaktieren eines Kontaktpartners umfasst eine wenigstens abschnittsweise hülsenartig ausgebildete Gehäuseeinrichtung und eine abschnittsweise in der Gehäuseeinrichtung angeordnete Kontakteinrichtung, wobei die Prüfstiftvorrichtung zur Zusammenführung mit dem Kontaktpartner entlang einer Längserstreckungsrichtung der Prüfstiftvorrichtung ausgebildet ist, wobei die Kontakteinrichtung zumindest ein Prüfkontaktelement aufweist, welches zum elektrischen Kontaktieren eines Kontaktelements des Kontaktpartners seitlich zu der Längserstreckungsrichtung ausgebildet ist, wobei die Kontakteinrichtung derart ausgebildet ist, dass mittels des Prüfkontaktelements ein in der Längserstreckungsrichtung betrachtet benachbart einem ersten Kontaktbereich des Kontaktelements angeordneter zweiter Kontaktbereich des Kontaktelements unter Übergreifen des ersten Kontaktbereichs in der Längserstreckungsrichtung seitlich zu der Längserstreckungsrichtung kontaktierbar ist.

Erfindungsgemäß umfasst die Prüfstiftvorrichtung eine wenigstens abschnittsweise hülsenartig ausgebildete Gehäuseeinrichtung. Die Gehäuseeinrichtung kann auch vollständig hülsenartig ausgebildet sein. Weiter umfasst die Prüfstiftvorrichtung eine Kontakteinrichtung, welche abschnittsweise in der Gehäuseeinrichtung angeordnet ist und ihrerseits zumindest ein Prüfkontaktelement aufweist, welches zum elektrischen Kontaktieren eines Kontaktelements des Kontaktpartners ausgebildet ist. Vorteilhafterweise kann die Kontakteinrichtung zwei, vorzugsweise parallel nebeneinander angeordnete, Prüfkontaktelemente aufweisen, wobei jedes der Prüfkontaktelemente zum Kontaktieren eines jeweiligen Kontaktelements des Kontaktpartners ausgebildet sein kann.

Erfindungsgemäß ist die Prüfstiftvorrichtung zur Zusammenführung mit dem Kontaktpartner entlang einer Längserstreckungsrichtung der Prüfstiftvorrichtung ausgebildet, wobei das Kontaktelement mittels des Prüfkontaktelements seitlich zu der Längserstreckungsrichtung kontaktierbar ist. Mit anderen Worten erfolgt keine stirnseitige, sondern eine seitliche Kontaktierung des Kontaktpartners. Das Prüfkontaktelement kann zumindest abschnittsweise derart an der Prüfstiftvorrichtung bzw. der Kontakteinrichtung angeordnet sein, dass dieses das Kontaktelement seitlich kontaktieren kann.

Erfindungsgemäß ist die Kontakteinrichtung derart ausgebildet, dass mittels des Prüfkontaktelements ein in der Längserstreckungsrichtung betrachtet benachbart einem ersten Kontaktbereich des Kontaktelements angeordneter zweiter Kontaktbereich des Kontaktelements unter Übergreifen des ersten Kontaktbereichs in der Längserstreckungsrichtung seitlich zu der Längserstreckungsrichtung kontaktierbar ist. Mit anderen Worten ermöglicht die Ausbildung der Kontakteinrichtung, dass der in der Längserstreckungsrichtung betrachtet vor dem zweiten Kontaktbereich liegende erste Kontaktbereich bei der Kontaktierung des Kontaktpartners mittels des Prüfkontaktelements nicht kontaktiert wird, so dass dieser vollständig frei von möglichen Kratzern und mithin unversehrt erhalten bleibt, während lediglich der in der Längserstreckungsrichtung betrachtet hinter dem ersten Kontaktbereich liegende zweite Kontaktbereich bei der Kontaktierung des Kontaktpartners mittels des Prüfkontaktelements kontaktiert wird. Der erste Kontaktbereich kann dann einen Kontaktabschnitt des Kontaktelements ausbilden, welcher bei einer bestimmungsgemäßen Verwendung des Kontaktpartners von einem Gegenkontaktelement eines mit dem Kontaktpartner zusammenwirkenden Verbindungspartners kontaktiert werden kann, während der zweite Kontaktbereich lediglich eine Art Prüfkontaktabschnitt des Kontaktelements ausbilden kann, welcher bei der bestimmungsgemäßen Verwendung des Kontaktpartners nicht von dem Gegenkontaktelement kontaktiert werden kann. Bei der Prüfung des Kontaktpartners mittels der Prüfstiftvorrichtung möglicherweise entstandene Kratzer sind dann ausschließlich auf dem zweiten Kontaktbereich zu finden, was einerseits für Abnehmer des Kontaktpartners akzeptabel ist und andererseits keinerlei nachteilhafte Auswirkungen auf eine Qualität einer bei der bestimmungsgemäßen Verwendung des Kontaktpartners ausgebildeten Kontaktierung des Kontaktpartners mit dem Verbindungspartner nach sich zieht. Dadurch, dass das Prüfkontaktelement den ersten Kontaktbereich übergreift und mögliche Kratzer nur auf dem zweiten Kontaktbereich entstehen können, wo diese nicht stören, ermöglich die erfindungsgemäße Prüfstiftvorrichtung eine kratzarme Kontaktierung eines Kontaktpartners.

Der Kontaktpartner kann beispielsweise als eine Buchse ausgebildet sein oder eine Buchse aufweisen, wobei das Kontaktelement an einer parallel zu der Längserstreckungsrichtung verlaufenden Seitenwand eines Gehäuses des Kontaktpartners angeordnet sein kann, wobei die Prüfstiftvorrichtung zur Zusammenführung mit dem Kontaktpartner in die Buchse eingeführt werden kann. Schon bei der Einführung bzw. beim Einschieben kann das Prüfkontaktelement den ersten Kontaktbereich zumindest teilweise übergreifen. Der Verbindungspartner kann beispielsweise ein in die Buchse einsteckbarer Stecker sein.

In einer bevorzugten Ausführungsform der Erfindung kann die Kontakteinrichtung einen in der Längserstreckungsrichtung endseitig der Prüfstiftvorrichtung angeordneten, abschnittsweise in der Gehäuseeinrichtung sowie in und entgegen der Längserstreckungsrichtung bewegbar gelagerten Kolben aufweisen, welcher in einer Nichtkontaktposition der Prüfstiftvorrichtung, in welcher das Kontaktelement mittels des Prüfkontaktelements nicht kontaktierbar ist, mittels zumindest eines Federelements der Kontakteinrichtung an einem, vorzugsweise von der Gehäuseeinrichtung ausgebildeten, ersten Anschlagelement anliegend vorgespannt sein kann, wobei der Kolben zu einem positionsabhängigen Zusammenwirken mit dem Prüfkontaktelement ausgebildet sein kann, derart, dass bei einem sukzessiven Einfedern des Kolbens entgegen der Längserstreckungsrichtung das Prüfkontaktelement wenigstens abschnittsweise sukzessive seitlich zu der Längserstreckungsrichtung bewegbar, insbesondere neigbar, sein kann, wobei der zweite Kontaktbereich in einer durch einen Arbeitshub des Kolbens definierten Kontaktposition der Prüfstiftvorrichtung mittels des Prüfkontaktelements kontaktierbar sein kann. Es kann dann zunächst die Zusammenführung der Prüfstiftvorrichtung mit dem Kontaktpartner erfolgen, wobei der erste Kontaktbereich zumindest so weit übergriffen werden kann, dass der erste Kontaktbereich spätestens nach einer der Zusammenführung nachfolgenden Überführung der Prüfstiftvorrichtung von der Nichtkontaktposition in die Kontaktposition von dem Prüfkontaktelement vollständig übergriffen werden kann, so dass das Prüfkontaktelement den zweiten Kontaktbereich kontaktieren kann. Da sich die Prüfstiftvorrichtung bei der Zusammenführung in der Nichtkontaktposition befinden kann, in welcher das Prüfkontaktelement das Kontaktelement nicht kontaktieren kann, kann ein Zerkratzen des Kontaktelements bei der Zusammenführung vermieden werden. Eine Dimension des Kolbes, des Prüfkontaktelements und eine Anordnung des Prüfkontaktelements relativ zu dem Kolben können derart aufeinander abgestimmt sein, dass das Übergreifen des ersten Kontaktbereichs zumindest anteilig möglich ist. Vorteilhafterweise kann der Kolben verdrehsicher in der Gehäuseeinrichtung gelagert sein. Dabei kann der Kolben ein gewisses seitliches Spiel besitzen, also in einer senkrecht zu der Längserstreckungsrichtung verlaufenden Ebene bewegbar in der Gehäuseeinrichtung gelagert sein. Als Federelement kann beispielsweise eine Schraubenfeder vorgesehen sein, welche in der Gehäuseeinrichtung angeordnet sein kann.

Vorteilhafterweise kann der Kolben in der Kontaktposition an einem zweiten Anschlagelement anliegen. Hierbei kann die Vorrichtung an der Gehäuseeinrichtung und/oder am Flansch vorgesehene Ausgleichsmittel wie beispielsweise ein zusätzliches Feder- oder Pufferelement, beispielsweise aus Kunststoff, aufweisen, welches in der Kontaktposition und bei einer Anlage des Kolbens am zweiten Anschlagelement eine zusätzliche Federmöglichkeit in Längserstreckungsrichtung bereitstellt.

Die Prüfstiftvorrichtung oder die Kontakteinrichtung kann einen, beispielsweise aus einem Kunststoffmaterial ausgebildeten, Einsatz umfassen, welcher in die Gehäuseeinrichtung eingesetzt sein und das zweite Anschlagelement ausbilden kann. Weiter kann der Einsatz auch zur abschnittsweisen Führung und/oder Befestigung des Prüfkontaktelements dienen. Der Einsatz kann zweiteilig ausgebildet sein und ein erstes Einsatzelement sowie ein zweites Einsatzelement umfassen. Alternativ kann das zweite Anschlagelement auch von der Gehäuseeinrichtung ausgebildet werden.

Vorteilhafterweise kann der Kolben aus einem Kunststoffmaterial ausgebildet sein und/oder einen zumindest näherungsweise rechteckigen, insbesondere quadratischen, Querschnitt aufweisen. Eine Ausbildung des Kolbens aus einem Kunststoffmaterial kann sicherstellen, dass das Kontaktelement bei einer Kontaktierung des Kontaktelements mit dem Kolben nicht zerkratzt werden kann. Weiter kann der Kolben auch einen zumindest näherungsweise runden, insbesondere kreisförmigen, Querschnitt aufweisen.

Vorteilhafterweise kann der Kolben außerhalb der Gehäuseeinrichtung einen in Eingriff mit dem Kontaktpartner bringbaren, insbesondere in eine Buchse einführbaren, Kolbenabschnitt mit einer dem Kontaktelement bei Ineingriffbringung des Kolbenabschnitts mit dem Kontaktpartner zuwendbaren Seitenfläche aufweisen. Der Kolbenabschnitt kann in der Längserstreckungsrichtung verlaufen. Die Gehäuseeinrichtung kann in der Längserstreckungsrichtung endseitig einen Durchgang aufweisen, durch welche der abschnittsweise in der Gehäuseeinrichtung gelagerte Kolben, insbesondere mit dem Kolbenabschnitt, aus der Gehäuseeinrichtung nach außen herausragen kann. Weiter kann der Kolben endseitig eine Stirnseite aufweisen, welche an dem Kontaktpartner, insbesondere an einer Rückwand der Buchse, anlegbar sein kann, wodurch die Zusammenführung der Prüfstiftvorrichtung mit dem Kontaktpartner begrenzt werden kann.

Zweckmäßigerweise kann in dem Kolben zumindest ein Durchgang ausgebildet sein, in welchem das Prüfkontaktelement abschnittsweise aufgenommen sein kann, wobei der Durchgang in eine in der Seitenfläche ausgebildete Öffnung münden kann, so dass das Prüfkontaktelement in der Kontaktposition das Kontaktelement durch die Öffnung kontaktieren kann. Folglich kann das Prüfkontaktelement einen den Kolben durchziehenden ersten Abschnitt aufweisen, welcher in der Nichtkontaktposition im Wesentlichen vollständig in dem Durchgang aufgenommen bzw. in dem Durchgang zumindest derart angeordnet sein kann, so dass eine Kontaktierung des Kontaktelements mittels des Prüfkontaktelements nicht möglich ist. Durch eine Bewegung des Kolbens entgegen der Längserstreckungsrichtung kann das Prüfkontaktelement dann in der Kontaktposition durch die Öffnung hindurch mit einer Spitze des Prüfkontaktelements das Kontaktelement kontaktieren. Dabei kann das Prüfkontaktelement die Öffnung durchgreifen oder bündig mit einer Oberfläche des Kolbens benachbart der Öffnung abschließen. Wenn die Kontakteinrichtung zwei Prüfkontaktelemente aufweist, können zwei derartige Durchgänge vorgesehen sein, welche parallel nebeneinander verlaufen können.

In einer konstruktiv vorteilhaften Ausgestaltung der Erfindung kann die Öffnung als eine Aussparung zur Aufnahme des Kontaktelements ausgebildet sein. Mit anderen Worten kann die Öffnung im Hinblick auf Abmessungen der Öffnung derart ausgebildet sein, dass sie sowohl die Kontaktierung des Kontaktelements mittels des Prüfkontaktelements als auch die Aufnahme des Kontaktelements ermöglicht. Dadurch kann eine Kontaktierung des Kontaktelements mit dem Kolben bzw. der Seitenfläche vermieden werden, so dass Kratzer auf dem Kontaktelement bei der Ineingriffbringung des Kolbenabschnitts mit dem Kontaktpartner vermieden werden können. Die Öffnung bzw. Aussparung kann auf der Seitenfläche ausgehend von der Stirnseite entgegen der Längserstreckungsrichtung verlaufen. Wenn die Kontakteinrichtung zwei Prüfkontaktelemente aufweist, können zwei derartige Aussparungen vorgesehen sein, welche parallel nebeneinander verlaufen können.

Gemäß einer zweckmäßigen konstruktiven Ausgestaltung der Erfindung kann der Durchgang einen in der Längserstreckungsrichtung verlaufenden ersten Durchgangsabschnitt und einen sich an den ersten Durchgangsabschnitt in der Längserstreckungsrichtung anschließenden zweiten Durchgangsabschnitt aufweisen, wobei der zweite Durchgangsabschnitt schräg zu der Längserstreckungsrichtung verlaufen und in der Öffnung münden kann, wobei das Prüfkontaktelement bei dem Einfedern des Kolbens infolge des schrägen Verlaufs des zweiten Durchgangsabschnitts mittels des Kolbens sukzessive seitlich zu der Längserstreckungsrichtung drückbar sein kann. Durch eine in einem Material des Kolbens ausgebildete Formschräge kann das Prüfkontaktelement dann gegen das Kontaktelement gedrückt werden.

Vorteilhafterweise kann das Prüfkontaktelement in und entgegen der Längserstreckungsrichtung unbewegbar gegenüber der Gehäuseeinrichtung angeordnet sein. Gegenüber einer in bzw. gegen die Längserstreckungsrichtung auf das Prüfkontaktelement wirkenden Zugbelastung bzw. Druckbelastung kann das Prüfkontaktelement mithin fest gegenüber der Gehäuseeinrichtung angeordnet sein. Jedoch kann auch vorgesehen sein, dass das Prüfkontaktelement in und entgegen der Längserstreckungsrichtung ein gewisses axiales Spiel besitzt.

Weiter kann das Prüfkontaktelement abschnittsweise seitlich zu der Längserstreckungsrichtung bewegbar, insbesondere neigbar, gegenüber der Gehäuseeinrichtung angeordnet sein. Insbesondere kann zumindest der den Kolben durchziehende erste Abschnitt des Prüfkontaktelements und ein in der Nichtkontaktposition zwischen dem Kolben und dem Einsatz befindlicher zweiter Abschnitt des Prüfkontaktelements seitlich zu der Längserstreckungsrichtung bewegbar, insbesondere neigbar, gegenüber der Gehäuseeinrichtung angeordnet sein. Ein den Einsatz durchziehender dritter Abschnitt des Kontaktelements kann zumindest teilweise fest mit dem Einsatz verbunden sein bzw. ein in dem Einsatz ausgebildeter Durchgang kann zumindest teilweise so eng bemessen sein, dass eine seitliche Bewegung des Prüfkontaktelements in dem Durchgang des Einsatzes nur eingeschränkt oder gar nicht möglich ist.

Vorteilhafterweise kann das Prüfkontaktelement als ein, vorzugsweise federndes, Kontaktblech ausgebildet sein. Das Prüfkontaktelement kann aus einem blechartigen Material ausgebildet sein, welches biegbar sein kann. Das Kontaktblech kann über eine gesamte Länge des Kontaktblechs biegbar sein. Das Kontaktblech kann sich einem Verlauf des Durchgangs in dem Kolben bedingt durch die Biegbarkeit des Materials dann automatisch anpassen. Weiter kann das Prüfkontaktelement im Wesentlichen streifenförmig ausgebildet sein.

Weiter kann das Prüfkontaktelement einen in der Längserstreckungsrichtung verlaufenden ersten Prüfkontaktelementabschnitt und einen sich in der Längserstreckungsrichtung an den ersten Prüfkontaktelementabschnitt anschließenden zweiten Prüfkontaktelementabschnitt, welcher schräg zu der Längserstreckungsrichtung verlaufen kann, aufweisen. Folglich kann ein Verlauf des Prüfkontaktelements an einen Verlauf des in dem Kolben ausgebildeten Durchgangs durch eine entsprechende Ausbildung des Prüfkontaktelements angepasst sein.

Das Prüfkontaktelement kann einstückig und/oder die Prüfstiftvorrichtung in der Längserstreckungsrichtung mit einem linearen Abschnitt im Wesentlichen durchziehend sowie mit einem schräg von der Längserstreckungsrichtung hinweg abgewinkelten Abschnitt ausgebildet sein.

Auch kann das Prüfkontaktelement einerends mit Prüfsignalen bzw. Hochfrequenzsignalen beaufschlagbar bzw. können die Prüfsignale bzw. Hochfrequenzsignale dort abgreifbar sein und anderenends mit dem Kontaktelement kontaktierbar sein.

Die Prüfstiftvorrichtung kann für Prüfsignale bzw. Hochfrequenzsignale mit einer Frequenz von 1 GHz bis 15 GHz ausgelegt sein.

Weiter kann die Prüfstiftvorrichtung für eine Übertragungsgeschwindigkeit von 5 Gbps bis 10 Gbps ausgelegt sein.

Ferner kann sich das Prüfkontaktelement in der Längserstreckungsrichtung wenigstens über eine Länge der Gehäuseeinrichtung erstrecken.

In einer Ausführungsform der Erfindung kann die Gehäuseeinrichtung mehrteilig, vorzugsweise zweiteilig, ausgebildet sein. Die Gehäuseeinrichtung kann ein erstes Gehäuseelement und ein mit diesem verbundenes, darin teilweise aufgenommenes zweites Gehäuseelement umfassen. Das erste Gehäuseelement kann einen Flansch ausbilden, welcher eine Durchgangsöffnung aufweisen kann. Weiter kann die Gehäuseeinrichtung beispielsweise zylinderförmig ausgebildet sein. Ferner kann die Gehäuseeinrichtung aus einem Metall ausgebildet sein.

Vorteilhafterweise kann das Prüfkontaktelement einen Innenleiter ausbilden, wobei die Kontakteinrichtung ein einen Außenleiter ausbildendes Außenprüfkontaktelement aufweisen kann. Das Außenprüfkontaktelement kann als Groundkontakt vorgesehen sein, welcher beispielsweise eine Seitenwand eines Gehäuses einer Buchse von außen kontaktieren kann.

Das Außenprüfkontaktelement kann als ein Kontaktblech ausgebildet sein. Weiter kann das Außenprüfkontaktelement an der Gehäuseeinrichtung angeordnet bzw. befestigt sein, beispielsweise mittels eines Passstiftes. Ferner kann das Außenprüfkontaktelement einen in der Längserstreckungsrichtung verlaufenden ersten Abschnitt und einen an den ersten Abschnitt in der Längserstreckungsrichtung anschließenden, von der Längserstreckungsrichtung hinweg gebogenen zweiten Abschnitt aufweisen.

Weitere vorteilhafte Ausführungsformen der Vorrichtung ergeben sich aus den Merkmalsbeschreibungen der auf den Verfahrensanspruch 1 rückbezogenen Unteransprüche.

Bei dem erfindungsgemäßen Verfahren zum lösbaren Kontaktieren eines Kontaktpartners mittels einer Hochfrequenz-Prüfstiftvorrichtung wird die Prüfstiftvorrichtung entlang einer Längserstreckungsrichtung der Prüfstiftvorrichtung mit dem Kontaktpartner zusammengeführt, wobei mittels zumindest eines Prüfkontaktelements einer abschnittsweise in einer wenigstens abschnittsweise hülsenartig ausgebildeten Gehäuseeinrichtung der Prüfstiftvorrichtung angeordneten Kontakteinrichtung der Prüfstiftvorrichtung ein Kontaktelement des Kontaktpartners seitlich zu der Längserstreckungsrichtung elektrisch kontaktiert wird, wobei mittels des Prüfkontaktelements ein in der Längserstreckungsrichtung betrachtet benachbart einem ersten Kontaktbereich des Kontaktelements angeordneter zweiter Kontaktbereich des Kontaktelements unter Übergreifen des ersten Kontaktbereichs in der Längserstreckungsrichtung seitlich zu der Längserstreckungsrichtung kontaktiert wird. Zu den vorteilhaften Wirkungen des erfindungsgemäßen Verfahrens wird auf die Vorteilsbeschreibung der erfindungsgemäßen Prüfstiftvorrichtung verwiesen.

Vorteilhafterweise kann der von dem Prüfkontaktelement übergriffene und von dem Prüfkontaktelement nicht kontaktierte erste Kontaktbereich bei dem Kontaktieren des Kontaktpartners frei von Kratzern bleiben.

In einer bevorzugten Ausführungsform des Verfahrens kann der erste Kontaktbereich beim Zusammenführen der Prüfstiftvorrichtung mit dem Kontaktpartner zumindest teilweise in der Längserstreckungsrichtung übergriffen werden. Der erste Kontaktbereich kann auch bereits vollständig beim Zusammenführen der Prüfstiftvorrichtung mit dem Kontaktpartner übergriffen werden.

Weiter kann die Prüfstiftvorrichtung mit dem Kontaktpartner zusammengeführt werden, wobei die Prüfstiftvorrichtung nachfolgend aus einer Nichtkontaktposition der Prüfstiftvorrichtung, in welcher das Prüfkontaktelement das Kontaktelement nicht kontaktiert, in eine Kontaktposition der Prüfstiftvorrichtung, in welcher das Prüfkontaktelement den zweiten Kontaktbereich kontaktiert, überführt werden kann.

In einer bevorzugten Ausführungsform des Verfahrens kann der erste Kontaktbereich beim Überführen der Prüfstiftvorrichtung aus der Nichtkontaktposition in die Kontaktposition zumindest teilweise in der Längserstreckungsrichtung übergriffen werden. Ein teilweises Übergreifen des ersten Kontaktbereiches kann bereits bei dem Zusammenführen der Prüfstiftvorrichtung mit dem Kontaktpartner erfolgt sein. Auch kann vorgesehen sein, dass der erste Kontaktbereich bei dem Zusammenführen der Prüfstiftvorrichtung mit dem Kontaktpartner noch überhaupt nicht anteilig übergriffen wird, so dass das Übergreifen erst beim Überführen der Prüfstiftvorrichtung aus der Nichtkontaktposition in die Kontaktposition erfolgen kann.

Vorteilhafterweise kann die Prüfstiftvorrichtung mit dem Kontaktpartner zusammengeführt werden derart, dass ein außerhalb der Gehäuseeinrichtung befindlicher Kolbenabschnitt eines in der Längserstreckungsrichtung endseitig der Prüfstiftvorrichtung angeordneten, abschnittsweise in der Gehäuseeinrichtung sowie in und entgegen der Längserstreckungsrichtung bewegbar gelagerten Kolbens der Kontakteinrichtung in Eingriff mit dem Kontaktpartner gebracht, insbesondere in eine Buchse eingeführt, werden kann, wobei der Kolben in der Nichtkontaktposition der Prüfstiftvorrichtung mittels zumindest eines Federelements der Kontakteinrichtung an einem, vorzugsweise von der Gehäuseeinrichtung ausgebildeten, ersten Anschlagelement anliegend vorgespannt sein kann, wobei die Prüfstiftvorrichtung dadurch in die Kontaktposition überführt werden kann, dass der Kolben bis zu einem Erreichen eines Arbeitshubs des Kolbens entgegen der Längserstreckungsrichtung sukzessive eingefedert werden kann, so dass das Prüfkontaktelement zur Kontaktierung des zweiten Kontaktbereichs wenigstens abschnittsweise sukzessive seitlich zu der Längserstreckungsrichtung bewegt, insbesondere geneigt, werden kann.

Weitere vorteilhafte Ausführungsformen des Verfahrens ergeben sich aus den Merkmalsbeschreibungen der auf den Vorrichtungsanspruch 1 rückbezogenen Unteransprüche.

Nachfolgend werden bevorzugte Ausführungsformen der Erfindung unter Bezugnahme auf die beigefügten Zeichnungen näher erläutert.

Es zeigen:
- **Fig. 1**: eine Seitenansicht einer Hochfrequenz-Prüfstiftvorrichtung;
- **Fig. 2**: eine Aufsicht der Prüfstiftvorrichtung;
- **Fig. 3**: eine Untersicht der Prüfstiftvorrichtung;
- **Fig. 4**: eine perspektivische Ansicht der Prüfstiftvorrichtung;
- **Fig. 5**: eine Vorderansicht der Prüfstiftvorrichtung;
- **Fig. 6**: eine Rückansicht der Prüfstiftvorrichtung;
- **Fig. 7**: eine Seitenansicht der Prüfstiftvorrichtung;
- **Fig. 8**: eine Schnittansicht der Prüfstiftvorrichtung entlang einer in der Fig. 7 gezeigten Achse A-A;
- **Fig. 9**: eine Schnittansicht der Prüfstiftvorrichtung entlang einer in der Fig. 8 gezeigten Achse B-B;
- **Fig. 10**: eine Seitenansicht der mit einem teilweise geschnitten dargestellten Kontaktpartner zusammengeführten Prüfstiftvorrichtung in einer Nichtkontaktposition;
- **Fig. 11**: eine Seitenansicht der mit dem teilweise geschnitten dargestellten Kontaktpartner zusammengeführten Prüfstiftvorrichtung in einer Kontaktposition;
- **Fig. 12**: eine Seitenansicht der mit dem geschnitten dargestellten Kontaktpartner zusammengeführten Prüfstiftvorrichtung in der Kontaktposition;
- **Fig. 13**: eine Schnittansicht der mit dem Kontaktpartner zusammengeführten Prüfstiftvorrichtung in der Kontaktposition entlang einer in der Fig. 12 gezeigten Achse G-G;
- **Fig. 14**: eine Schnittansicht der mit dem Kontaktpartner zusammengeführten Prüfstiftvorrichtung in der Kontaktposition entlang einer in der Fig. 13 gezeigten Achse J-J.

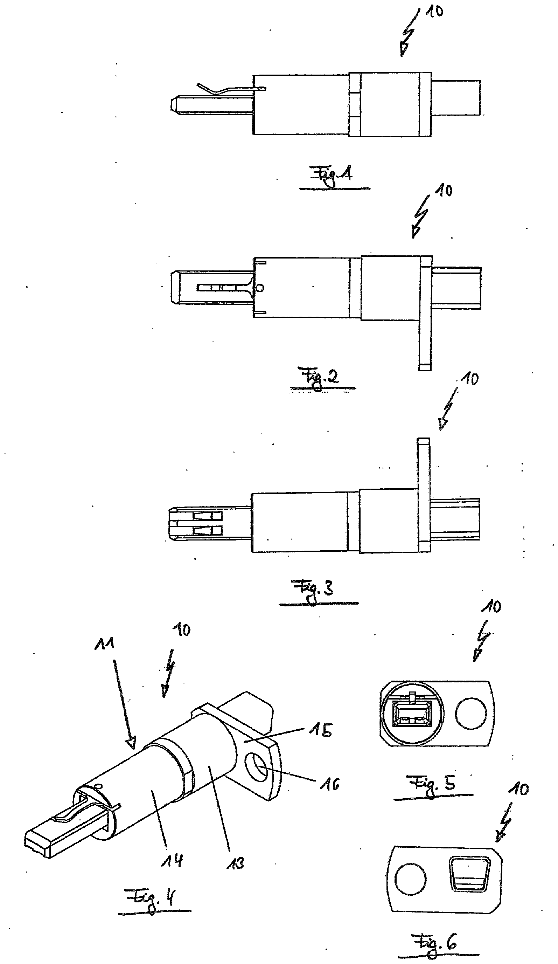

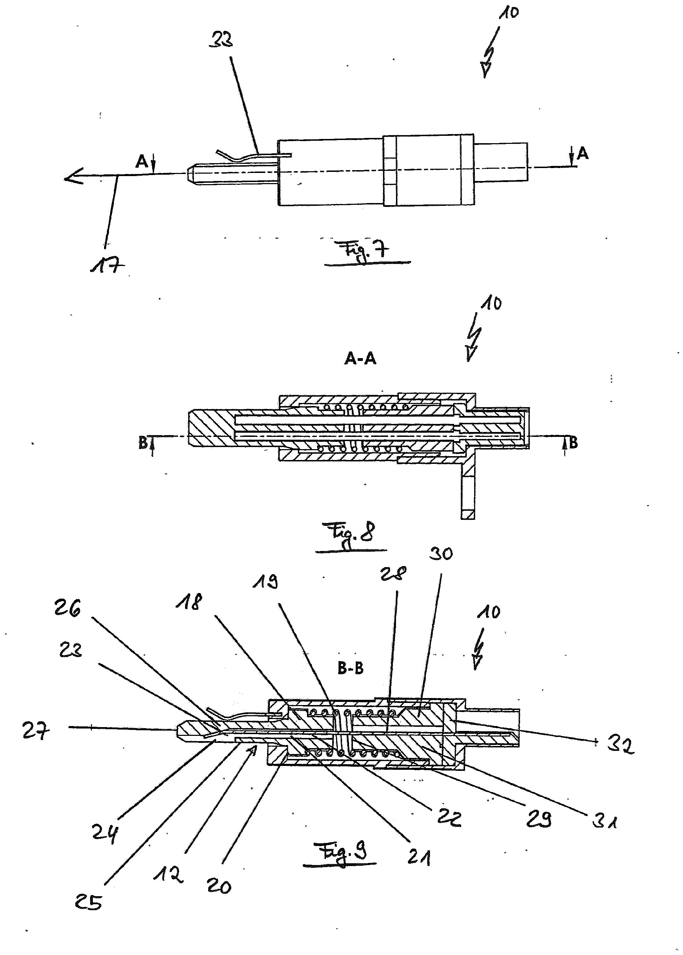

Eine Zusammenschau der **Fig. 1** bis **9** zeigt eine Hochfrequenz-Prüfstiftvorrichtung 10, welche eine hülsenartig ausgebildete Gehäuseeinrichtung 11 und eine abschnittsweise in der Gehäuseeinrichtung 11 angeordnete Kontakteinrichtung 12 umfasst.

Die zylinderförmig ausgestaltete Gehäuseeinrichtung 11 ist zweiteilig ausgebildet und umfasst ein erstes Gehäuseelement 13 und ein zweites Gehäuseelement 14. Das erste Gehäuseelement 13 bildet einen Flansch 15 aus, welcher eine Durchgangsöffnung 16 aufweist.

Die Kontakteinrichtung 12 weist einen in einer Längserstreckungsrichtung 17 der Prüfstiftvorrichtung 10 endseitig der Prüfstiftvorrichtung 10 angeordneten, abschnittsweise in der Gehäuseeinrichtung 11 sowie in und entgegen der Längserstreckungsrichtung 17 bewegbar gelagerten Kolben 18 auf, welcher in einer Nichtkontaktposition der Prüfstiftvorrichtung 10 mittels eines als eine Schraubenfeder ausgebildeten, in der Gehäuseeinrichtung 11 angeordneten Federelements 19 der Kontakteinrichtung 12 an einem von der Gehäuseeinrichtung 11 ausgebildeten ersten Anschlagelement 20 anliegend vorgespannt ist.

In dem Kolben 18 sind zwei parallel nebeneinander verlaufende Durchgänge 21 ausgebildet, von welchen jeder einen in der Längserstreckungsrichtung 17 verlaufenden ersten Durchgangsabschnitt 22 und einen sich an den ersten Durchgangsabschnitt 22 in der Längserstreckungsrichtung 17 anschließenden zweiten Durchgangsabschnitt 23 aufweist, wobei der zweite Durchgangsabschnitt 23 jeweils schräg zu der Längserstreckungsrichtung 17 verläuft und jeweils in einer als eine Aussparung ausgebildeten Öffnung 24 mündet, welche jeweils in einer Seitenfläche 25 eines außerhalb der Gehäuseeinrichtung 11 befindlichen Kolbenabschnitts 26 des Kolbens 18 ausgebildet ist. Die Öffnungen 24 verlaufen ausgehend von einer Stirnseite 27 des Kolbens 18 parallel nebeneinander entgegen der Längserstreckungsrichtung 17. Der Kolben 18 ist aus einem Kunststoffmaterial ausgebildet und weist einen im Wesentlichen rechteckigen Querschnitt auf.

Weiter weist die Kontakteinrichtung 12 zwei parallel nebeneinander angeordnete, als Kontaktbleche ausgebildete Prüfkontaktelemente 28 auf, welche die Gehäuseeinrichtung 11 in der Längserstreckungsrichtung 17 durchziehen und jeweils abschnittsweise in einem der Durchgänge 21 angeordnet sind.

Der Kolben 18 ist zu einem positionsabhängigen Zusammenwirken mit den Prüfkontaktelementen 28 ausgebildet, derart, dass bei einem sukzessiven Einfedern des Kolbens 18 entgegen der Längserstreckungsrichtung 17 die Prüfkontaktelemente 28 infolge des schrägen Verlaufs der zweiten Durchgangsabschnitte 23 solange sukzessive seitlich zu der Längserstreckungsrichtung 17 biegbar sind, bis der Kolben 18 einen eine Kontaktposition der Prüfstiftvorrichtung 10 definierenden Arbeitshub erreicht hat. Bei diesem kann der Kolben 18 an einem zweiten Anschlagelement 29 anliegen, welcher von einem in die Gehäuseeinrichtung 11 eingesetzten Einsatz 30 der Prüfstiftvorrichtung 10 bzw. der Kontakteinrichtung 12 ausgebildet wird, oder einen minimalen Spalt mit dem zweiten Anschlagelement 29 ausbilden. Zusätzlich kann die Vorrichtung an der Gehäuseeinrichtung 11 und/oder am Flansch 15 vorgesehene Ausgleichsmittel (nicht gezeigt) wie beispielsweise ein zusätzliches Feder- oder Pufferelement, beispielsweise aus Kunststoff, aufweisen, welches in der Kontaktposition und bei einer Anlage des Kolbens 18 am zweiten Anschlagelement 29 eine zusätzliche Federmöglichkeit in Längserstreckungsrichtung 17 bereitstellt. Der Einsatz 30, welcher insbesondere auch der Führung und Befestigung der Prüfkontaktelemente 28 dient, ist zweiteilig ausgebildet und umfasst ein erstes Einsatzelement 31 und ein zweites Einsatzelement 32.

Weiter weist die Kontakteinrichtung 12 ein Außenprüfkontaktelement 33 auf, welches einen Außenleiter bzw. einen Groundkontakt ausbildet. Die Prüfkontaktelemente 28 bilden Innenleiter aus. Das Außenprüfkontaktelement 33, welches ebenfalls als ein Kontaktblech ausgebildet ist, ist an der Gehäuseeinrichtung 11 angeordnet, wobei das Außenprüfkontaktelement 33 zunächst in der Längserstreckungsrichtung 17 verläuft und daran anschließend schräg von der Längserstreckungsrichtung 17 hinweg verlaufend, gebogen bzw. abgewinkelt ausgebildet ist.

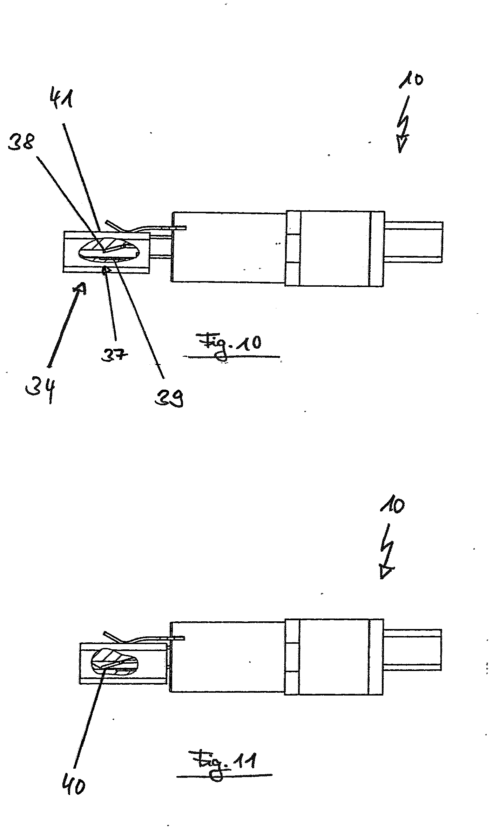

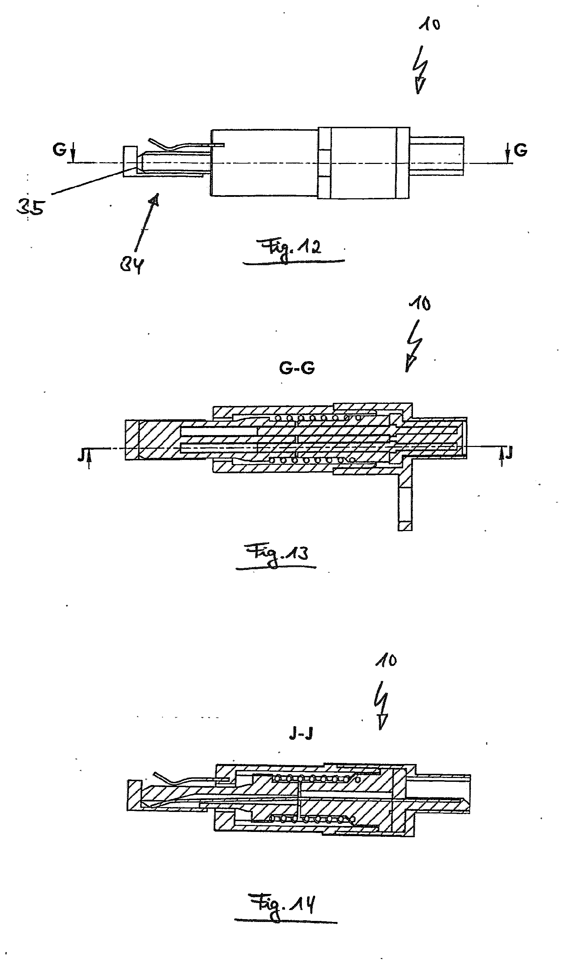

Eine Zusammenschau der **Fig. 10** bis **14** zeigt ein lösbares Kontaktieren eines als eine Buchse ausgebildeten Kontaktpartners 34 mittels der Prüfstiftvorrichtung 10.

Bei dem lösbaren Kontaktieren des Kontaktpartners 34 wird die Prüfstiftvorrichtung 10 mit dem Kontaktpartner 34 entlang der Längserstreckungsrichtung 17 zusammengeführt, indem der Kolbenabschnitt 26 in Eingriff mit dem Kontaktpartner 34 gebracht bzw. in die Buchse eingeführt wird, bis die Stirnseite 27 an einer Rückwand 35 des Kontaktpartners 34 anliegt. Dabei erfolgt die Zusammenführung unter Zuwendung der Seitenfläche 25 zu zwei in der Längserstreckungsrichtung 17 parallel nebeneinander verlaufenden, auf einer unteren Seitenwand 36 des Kontaktpartners 34 angeordneten Kontaktelementen 37, von denen hier lediglich eines zu sehen ist, so dass die Kontaktelemente 37 jeweils in einer der Öffnungen 24 bzw. Aussparungen aufgenommen werden. Bei der Zusammenführung befindet sich die Prüfstiftvorrichtung 10 in der Nichtkontaktposition, in der die Kontaktelemente 37 nicht mittels der Prüfkontaktelemente 28 elektrisch kontaktierbar sind. Jeweils eine Spitze 38 der Prüfkontaktelemente 28 ist in der Nichtkontaktposition derart in den Durchgängen 21 aufgenommen, dass diese bei der Zusammenführung von den Kontaktelementen 37 beabstandet geführt wird. Dadurch können mögliche Kratzer auf den Kontaktelementen 37 bei der Zusammenführung vermieden werden. Die Kontaktelemente 37 weisen jeweils einen in der Längserstreckungsrichtung 17 betrachtet ersten Kontaktbereich 39 und einen benachbart dem ersten Kontaktbereich 39 angeordneten zweiten Kontaktbereich 40 auf. Bei der Zusammenführung übergreifen die Prüfkontaktelemente 28 mit ihrer Spitze 38 jeweils den jeweiligen ersten Kontaktbereich 39 in der Längserstreckungsrichtung 17 teilweise, so dass der jeweilige erste Kontaktbereich 38 nach der Zusammenführung und in der Nichtkontaktposition der Prüfstiftvorrichtung 10 teilweise von dem jeweiligen Prüfkontaktelement 28 übergriffen ist. Weiter liegt das Außenprüfkontaktelement 33 bereits nach der Zusammenführung außen an einer oberen Seitenwand 41 des Kontaktpartners 34 an.

Nach der Zusammenführung wird die Prüfstiftvorrichtung 10 in die Kontaktposition überführt, indem der Kolben 18 bis zum Erreichen des Arbeitshubs entgegen der Längserstreckungsrichtung 17 sukzessive eingefedert wird, wodurch die Prüfkontaktelemente 28 jeweils mit der Spitze 38 sukzessive seitlich zu der Längserstreckungsrichtung 17 bewegt werden. Dabei bewegt sich die Gehäuseeinrichtung 11 in der Längserstreckungsrichtung 17 auf die Rückwand 35 zu, so dass sich die in und entgegen der Längserstreckungsrichtung unbewegbar gegenüber der Gehäuseeinrichtung 11 angeordneten Prüfkontaktelemente 28 in der Längserstreckungsrichtung 17 ebenfalls auf die die Rückwand 35 zubewegen. Dabei übergreifen die Prüfkontaktelemente 28 den jeweiligen ersten Kontaktbereich 39 weiter, so dass die Prüfkontaktelemente 28 in der Kontaktposition den jeweiligen zweiten Kontaktbereich 40 seitlich zu der Längserstreckungsrichtung 17 elektrisch kontaktieren. Mit anderen Worten ist die Kontakteinrichtung 12 derart ausgebildet, dass mittels der Prüfkontaktelemente 28 jeweils der zweite Kontaktbereich 40 unter Übergreifen des ersten Kontaktbereichs 39 kontaktierbar ist. Durch das Übergreifen des ersten Kontaktbereiches 39 bleibt der erste Kontaktbereich 39 frei von Kratzern. Mögliche Kratzer, die bei der Kontaktierung des zweiten Kontaktbereiches 40 entstehen können, können, insbesondere abnehmerseitig, in Kauf genommen werden.

### Bezugszeichenliste

- 10: Hochfrequenz-Prüfstiftvorrichtung
- 11: Gehäuseeinrichtung
- 12: Kontakteinrichtung
- 13: erstes Gehäuseelement
- 14: zweites Gehäuseelement
- 15: Flansch
- 16: Durchgangsöffnung
- 17: Längserstreckungsrichtung
- 18: Kolben
- 19: Federelement
- 20: erstes Anschlagelement
- 21: Durchgang
- 22: erster Durchgangsabschnitt
- 23: zweiter Durchgangsabschnitt
- 24: Öffnung
- 25: Seitenfläche
- 26: Kolbenabschnitt
- 27: Stirnseite
- 28: Prüfkontaktelement
- 29: zweites Anschlagelement
- 30: Einsatz
- 31: erstes Einsatzelement
- 32: zweites Einsatzelement
- 33: Außenprüfkontaktelement
- 34: Kontaktpartner
- 35: Rückwand
- 36: untere Seitenwand
- 37: Kontaktelement
- 38: Spitze
- 39: erster Kontaktbereich
- 40: zweiter Kontaktbereich
- 41: obere Seitenwand

## Patentansprüche

1. Hochfrequenz-Prüfstiftvorrichtung (10) zum lösbaren Kontaktieren eines Kontaktpartners (34), umfassend eine wenigstens abschnittsweise hülsenartig ausgebildete Gehäuseeinrichtung (11) und eine abschnittsweise in der Gehäuseeinrichtung angeordnete Kontakteinrichtung (12), wobei die Prüfstiftvorrichtung zur Zusammenführung mit dem Kontaktpartner entlang einer Längserstreckungsrichtung (17) der Prüfstiftvorrichtung ausgebildet ist, wobei die Kontakteinrichtung zumindest ein Prüfkontaktelement (28) aufweist, welches zum elektrischen Kontaktieren eines Kontaktelements (37) des Kontaktpartners seitlich zu der Längserstreckungsrichtung ausgebildet ist, wobei die Kontakteinrichtung derart ausgebildet ist, dass mittels des Prüfkontaktelements ein in der Längserstreckungsrichtung betrachtet benachbart einem ersten Kontaktbereich (39) des Kontaktelements angeordneter zweiter Kontaktbereich (40) des Kontaktelements unter Übergreifen des ersten Kontaktbereichs in der Längserstreckungsrichtung seitlich zu der Längserstreckungsrichtung kontaktierbar ist.

2. Prüfstiftvorrichtung nach Anspruch 1,
**dadurch gekennzeichnet,**
**dass** die Kontakteinrichtung (12) einen in der Längserstreckungsrichtung (17) endseitig der Prüfstiftvorrichtung (10) angeordneten, abschnittsweise in der Gehäuseeinrichtung (11) sowie in und entgegen der Längserstreckungsrichtung bewegbar gelagerten Kolben (18) aufweist, welcher in einer Nichtkontaktposition der Prüfstiftvorrichtung, in welcher das Kontaktelement (37) mittels des Prüfkontaktelements (28) nicht kontaktierbar ist, mittels zumindest eines Federelements (19) der Kontakteinrichtung an einem, vorzugsweise von der Gehäuseeinrichtung ausgebildeten, ersten Anschlagelement (20) anliegend vorgespannt ist, wobei der Kolben zu einem positionsabhängigen Zusammenwirken mit dem Prüfkontaktelement ausgebildet ist, derart, dass bei einem sukzessiven Einfedern des Kolbens entgegen der Längserstreckungsrichtung das Prüfkontaktelement wenigstens abschnittsweise sukzessive seitlich zu der Längserstreckungsrichtung bewegbar, insbesondere neigbar, ist, wobei der zweite Kontaktbereich (40) in einer durch einen Arbeitshub des Kolbens definierten Kontaktposition der Prüfstiftvorrichtung mittels des Prüfkontaktelements kontaktierbar ist.

3. Prüfstiftvorrichtung nach Anspruch 2,
**dadurch gekennzeichnet,**
**dass** der Kolben (18) aus einem Kunststoffmaterial ausgebildet ist und/oder einen zumindest näherungsweise rechteckigen Querschnitt aufweist.

4. Prüfstiftvorrichtung nach Anspruch 2 oder 3,
**dadurch gekennzeichnet,**
**dass** der Kolben (18) außerhalb der Gehäuseeinrichtung (11) einen in Eingriff mit dem Kontaktpartner (34) bringbaren, insbesondere in eine Buchse einführbaren, Kolbenabschnitt (26) mit einer dem Kontaktelement (37) bei Ineingriffbringung des Kolbenabschnitts mit dem Kontaktpartner zuwendbaren Seitenfläche (25) aufweist.

5. Prüfstiftvorrichtung nach Anspruch 4,
**dadurch gekennzeichnet,**
**dass** in dem Kolben (18) zumindest ein Durchgang (21) ausgebildet ist, in welchem das Prüfkontaktelement (28) abschnittsweise aufgenommen ist, wobei der Durchgang in eine in der Seitenfläche (25) ausgebildete Öffnung (24) mündet, so dass das Prüfkontaktelement in der Kontaktposition das Kontaktelement (37) durch die Öffnung kontaktieren kann, wobei die Öffnung (24) vorzugsweise als eine Aussparung zur Aufnahme des Kontaktelements (37) ausgebildet ist.

6. Prüfstiftvorrichtung nach Anspruch 5,
**dadurch gekennzeichnet,**
**dass** der Durchgang (21) einen in der Längserstreckungsrichtung (17) verlaufenden ersten Durchgangsabschnitt (22) und einen sich an den ersten Durchgangsabschnitt in der Längserstreckungsrichtung anschließenden zweiten Durchgangsabschnitt (23) aufweist, wobei der zweite Durchgangsabschnitt schräg zu der Längserstreckungsrichtung verläuft und in der Öffnung (24) mündet, wobei das Prüfkontaktelement (28) bei dem Einfedern des Kolbens (18) infolge des schrägen Verlaufs des zweiten Durchgangsabschnitts mittels des Kolbens sukzessive seitlich zu der Längserstreckungsrichtung drückbar ist.

7. Prüfstiftvorrichtung nach einem der vorangehenden Ansprüche,
**dadurch gekennzeichnet,**
**dass** das Prüfkontaktelement (28) in und entgegen der Längserstreckungsrichtung (17) unbewegbar gegenüber der Gehäuseeinrichtung (11) angeordnet ist.

8. Prüfstiftvorrichtung nach einem der vorangehenden Ansprüche,
**dadurch gekennzeichnet,**
**dass** das Prüfkontaktelement (28) abschnittsweise seitlich zu der Längserstreckungsrichtung (17) bewegbar, insbesondere neigbar, gegenüber der Gehäuseeinrichtung (11) angeordnet ist.

9. Prüfstiftvorrichtung nach einem der vorangehenden Ansprüche,
**dadurch gekennzeichnet,**
**dass** das Prüfkontaktelement (28) als ein, vorzugsweise federndes, Kontaktblech ausgebildet ist und/oder
**dass** sich das Prüfkontaktelement (28) in der Längserstreckungsrichtung (17) wenigstens über eine Länge der Gehäuseeinrichtung (11) erstreckt.

10. Prüfstiftvorrichtung nach einem der vorangehenden Ansprüche,
**dadurch gekennzeichnet,**
**dass** die Gehäuseeinrichtung (11) mehrteilig, vorzugsweise zweiteilig, ausgebildet ist und/oder dass das Prüfkontaktelement (28) einen Innenleiter ausbildet, wobei die Kontakteinrichtung (12) ein einen Außenleiter ausbildendes Außenprüfkontaktelement (33) aufweist.

11. Verfahren zum lösbaren Kontaktieren eines Kontaktpartners (34) mittels einer Hochfrequenz-Prüfstiftvorrichtung (10), wobei die Prüfstiftvorrichtung entlang einer Längserstreckungsrichtung (17) der Prüfstiftvorrichtung mit dem Kontaktpartner zusammengeführt wird, wobei mittels zumindest eines Prüfkontaktelements (28) einer abschnittsweise in einer wenigstens abschnittsweise hülsenartig ausgebildeten Gehäuseeinrichtung (11) der Prüfstiftvorrichtung angeordneten Kontakteinrichtung (12) der Prüfstiftvorrichtung ein Kontaktelement (37) des Kontaktpartners seitlich zu der Längserstreckungsrichtung elektrisch kontaktiert wird, wobei mittels des Prüfkontaktelements ein in der Längserstreckungsrichtung betrachtet benachbart einem ersten Kontaktbereich (39) des Kontaktelements angeordneter zweiter Kontaktbereich (40) des Kontaktelements unter Übergreifen des ersten Kontaktbereichs in der Längserstreckungsrichtung seitlich zu der Längserstreckungsrichtung kontaktiert wird.

12. Verfahren nach Anspruch 11,
**dadurch gekennzeichnet,**
**dass** der von dem Prüfkontaktelement (28) übergriffene und von dem Prüfkontaktelement nicht kontaktierte erste Kontaktbereich (39) bei dem Kontaktieren des Kontaktpartners (34) frei von Kratzern bleibt und/oder
**dass** der erste Kontaktbereich (39) beim Zusammenführen der Prüfstiftvorrichtung (10) mit dem Kontaktpartner (34) zumindest teilweise in der Längserstreckungsrichtung (17) übergriffen wird.

13. Verfahren nach Anspruch 11 oder 12,
**dadurch gekennzeichnet,**
**dass** die Prüfstiftvorrichtung (10) mit dem Kontaktpartner (34) zusammengeführt wird, wobei die Prüfstiftvorrichtung nachfolgend aus einer Nichtkontaktposition der Prüfstiftvorrichtung, in welcher das Prüfkontaktelement (28) das Kontaktelement (37) nicht kontaktiert, in eine Kontaktposition der Prüfstiftvorrichtung, in welcher das Prüfkontaktelement den zweiten Kontaktbereich kontaktiert, überführt wird.

14. Verfahren nach Anspruch 13,
**dadurch gekennzeichnet,**
**dass** der erste Kontaktbereich (39) beim Überführen der Prüfstiftvorrichtung (10) aus der Nichtkontaktposition in die Kontaktposition zumindest teilweise in der Längserstreckungsrichtung (17) übergriffen wird.

15. Verfahren nach Anspruch 13 oder 14,
**dadurch gekennzeichnet,**
**dass** die Prüfstiftvorrichtung (10) mit dem Kontaktpartner (34) zusammengeführt wird derart, dass ein außerhalb der Gehäuseeinrichtung (11) befindlicher Kolbenabschnitt (26) eines in der Längserstreckungsrichtung (17) endseitig der Prüfstiftvorrichtung angeordneten, abschnittsweise in der Gehäuseeinrichtung sowie in und entgegen der Längserstreckungsrichtung bewegbar gelagerten Kolbens (18) der Kontakteinrichtung (12) in Eingriff mit dem Kontaktpartner gebracht wird, insbesondere in eine Buchse eingeführt wird, wobei der Kolben in der Nichtkontaktposition der Prüfstiftvorrichtung mittels zumindest eines Federelements (19) der Kontakteinrichtung an einem, vorzugsweise von der Gehäuseeinrichtung ausgebildeten, ersten Anschlagelement (20) anliegend vorgespannt ist, wobei die Prüfstiftvorrichtung dadurch in die Kontaktposition überführt wird, dass der Kolben bis zu einem Erreichen eines Arbeitshubs des Kolbens entgegen der Längserstreckungsrichtung sukzessive eingefedert wird, so dass das Prüfkontaktelement (28) zur Kontaktierung des zweiten Kontaktbereichs (40) wenigstens abschnittsweise sukzessive seitlich zu der Längserstreckungsrichtung bewegt wird, insbesondere geneigt wird.
